# EUROPEAN PATENT SPECIFICATION

(11) **EP 3 949 048 B1**
(45) Date of publication and mention of the grant of the patent: **03.06.2026**
(21) Application number: 20723945.0
(22) Date of filing: 01.04.2020
(51) Int. Cl.: G01R 33/02, G01R 33/00, H02G 1/08, H02G 3/22

(54) **METHOD FOR LOCATING A MAGNET**
VERFAHREN ZUM LOKALISIEREN EINES MAGNETEN
PROCÉDÉ DE LOCALISATION D'UN AIMANT

(30) Priority: 02.04.2019 NL 1043215
(43) Date of publication of application: 09.02.2022
(73) Proprietor: TKF Telecom Solutions B.V., 7481 KJ Haaksbergen (NL)
(72) Inventor: KOPKA, Michael, 44265 Dortmund (DE); BEUMER, André, 58300 Wetter (Ruhr) (DE); KOHLMEYER, Guido, 44137 Dortmund (DE); BERLIN, Alexander, 44801 Bochum (DE); WALSWEER, Robertus Ferdinand, 8071HA Nunspeet (NL); KOKKELER, Franciscus Gerhardus Maria, 7522 CZ Enschede (NL)
(74) Representative: Mink-Lindenburg, Charlotte Hildegard
(86) International application number: PCT/NL2020/050219
(87) International publication number: WO 2020/204710

(56) References cited:
- GB-A- 2 363 462
- JP-A- 2011 226 836
- JP-A- H1 039 040
- US-A- 5 434 500
- US-A1- 2006 041 398
- US-A1- 2016 051 164

## Description

### Field of the invention

The invention relates to a method for locating a magnet. More in particular the invention concerns the accurate and quick determination of the location of a non-visible magnet, which is located in a wall.

### Background of the invention

NL 2015509 B1 describes a method for connecting a house, in particular in high-rise buildings, to a cable network, comprising bringing a cable of the network to a location on an outside wall of the house, forming a receiving space in the outside wall, bringing a part of the cable into the receiving space, looking up the receiving space containing the cable part from the inside of the house, and retrieving the cable part from the receiving space and leading it to a utility point in the house. For example, the part of the connection work outside the house can be carried out at any time, regardless of the presence of a resident, and the part of the connection works within the house can be carried out later at a time that suits a resident, which has great logistical advantages.

When the outer wall is a cavity wall, the cable part can be stored in the outer leaf and/or the cavity and/or the inner leaf of the cavity wall. At these locations enough space is available to store a fair amount of cable, so that the final connection point in the house does not have to coincide with the point where the cable goes through the outer wall, and enough cable length can be pulled into the house to be able to attach a connector to the cable end. In addition, the cable can be concealed invisibly both from the inside and the outside, while it is not in use.

In order to be able to find the cable part stored in the receiving space from the inside of the house, it is preferable that the location of the receiving space containing the cable part is marked, whereby the marked location is not visible to the eye from the inside of the house. The location can be marked by placing a magnet in the outside wall, and looking up the marked location on the inside of the house using a magnetometer or (electronic) compass.

Locating the non-visible magnet in the outer wall in a reasonable, fast and sufficiently accurate manner from the inside of the house proves impossible with known techniques due to environmental influences, inaccuracy of the measuring method, measurement data interpretation problems and a long measuring time. There is therefore a need for a fast and accurate measuring method for locating the invisible magnet, insensitive to, for example, reinforcing bars in the wall, electrical cabling and differences in wall material and wall density differences. The invention thereto provides such a measuring method.

It is noted that a method according to the preamble of appended claim 1 is known from JPH1039040. Other prior art documents are US2006/0041398A1 and US2016/0051164A1.

### Summary of the invention

The invention provides a method according to claim 1. The geometric quantity is a direction and a distance. The second means can comprise a display and the determined direction can be indicated on the display by lighting at least one of several display elements, and the determined distance can be indicated on the display by lighting at least one display element provided with a number. The location of the magnet, two-dimensional or three-dimensional, can thus be determined relative to the magnetometers or the device.

The invention is explained in more detail below with reference to exemplary embodiments.

### Brief description of the figures

In the figures:
- figure 1 shows a cross section of a cavity wall of a house with an opening in the outer leaf in which a cable part is stored and in the inner leaf a cavity in which a magnet is received; and
- figure 2 shows the retrieving of the cable part after locating and tapping the magnet;
- figure 3 shows a front view of a device according to the invention; and
- figures 4-10 show a bipolar bar magnet and four magnetometers at different positions in the magnetic field thereof.

### Exemplary embodiments

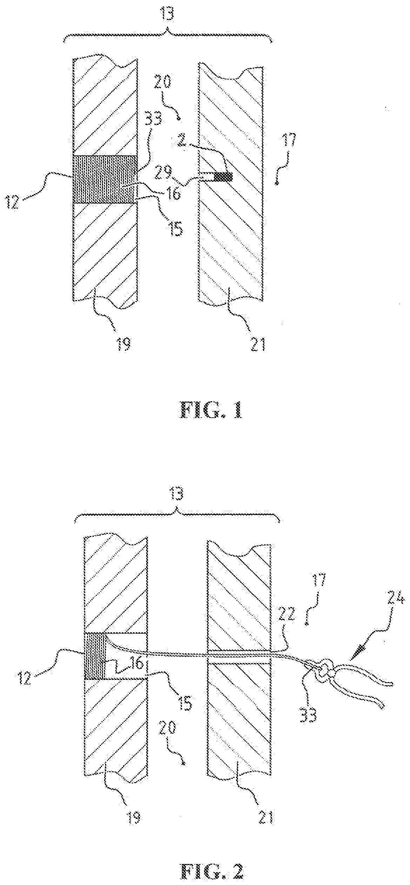

Figure 1 shows a cross-section of a cavity wall (13) of a house, from the outside of which an opening (15) is formed in the outer leaf (19) in which a cable part (16) is stored rolled up, and in the inner leaf (21) a cavity (29) is formed in which a magnet (2) is received to mark the location of the opening (15) and the cable part (16). In other embodiments, the cable part can also be stored, partly or wholly, in the cavity and/or a hollow in the inner leaf and/or the magnet can be received in the outer leaf and/or the magnet can be connected to the end of the cable part . At a later moment, the magnet (2) can be located and tapped from the inside of the house (22), after which the cable part (16) can be retrieved to be taken to a utility point in the house, as shown in figure 2.

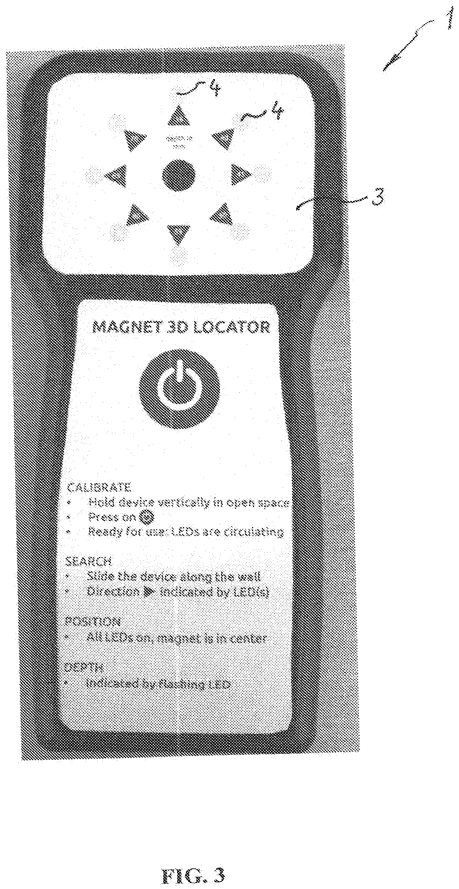

To locate the magnet (2), here a bipolar rod magnet with the magnetic axis perpendicular to the main plane of the cavity wall (13), a device (1) according to the invention as shown in figure 3 can be used. The device (1) comprises a number of, here four circularly arranged vectorial, magnetometers (M1-M4, not visible) and a display (3). A direction can be indicated on the display (3) by lighting up one or more display elements (4). The display elements (4), here eight arranged in a circle, are here provided with numbers, here ranging from 35 to 70. For example, a distance can also be displayed on the display (3), here the distance in millimeters between the magnet (2) and the magnetometers (M1-M4) or the device (1), by lighting up one of the display elements (4).

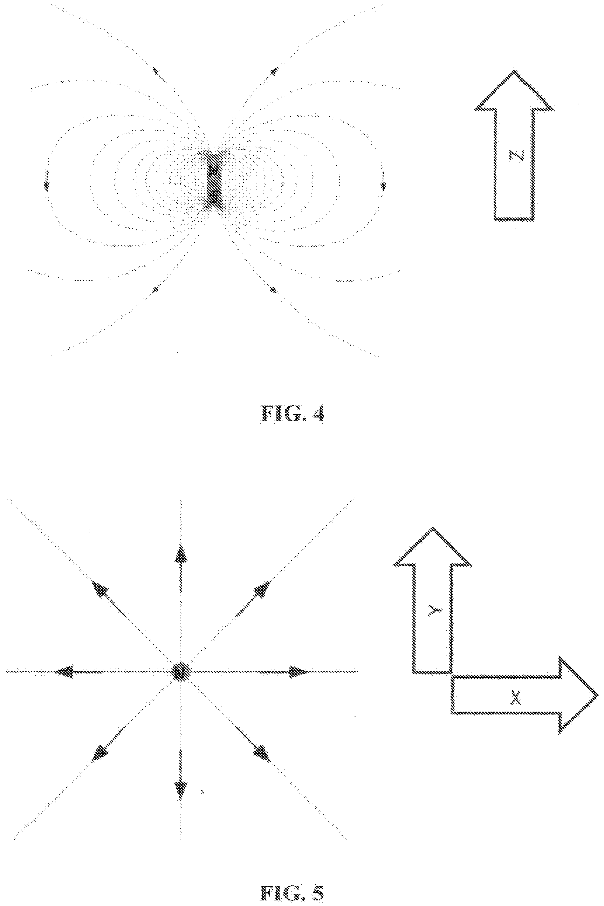

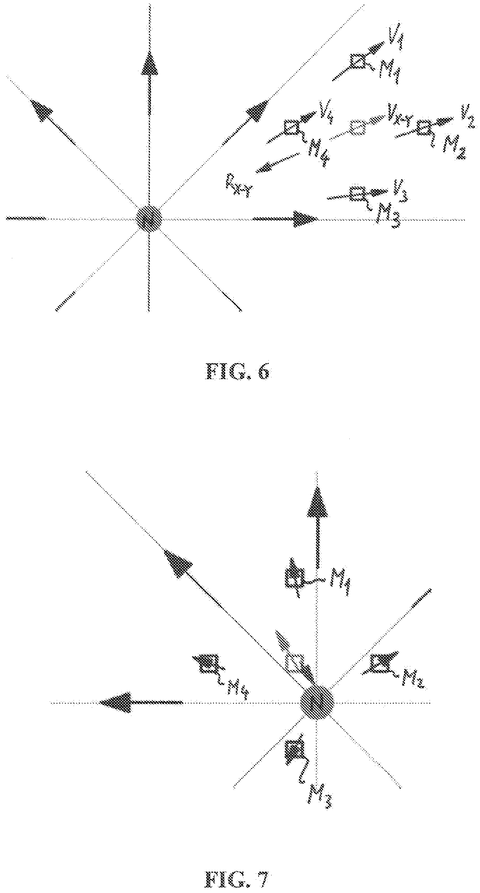

The magnet (2) and the known geometry of its magnetic field are shown schematically in Figure 4 (side view with the north pole (N) above) and Figure 5 (top view on the north pole (N)). Figure 6 again shows the magnetic field (top view on the north pole (N)) with currently the four magnetometers (M1-M4) located above the magnet (2) in a plane perpendicular to the magnetic axis. The magnetic field strengths (V1-V4) measured by the magnetometers (M1-M4) are added vectorially in the X-Y plane to a virtual vector (VX-Y). The (opposite) direction (RX-Y) is displayed on the display (3) by lighting up one or more of the display elements (4). Subsequently the device (1) is moved in the indicated direction (RX-Y), for example until the magnet (2) is 'within' the four magnetometers (M1-M4), as shown in figure 7. The magnetometers (M1- M4) are moved further and further until the indicated direction (RX-Y) is zero. The four magnetometers (M1-M4) are now in a neutral position, i.e. centrally in line with the magnet (2), so that the location of the magnet (2) is known in the X direction and Y direction.

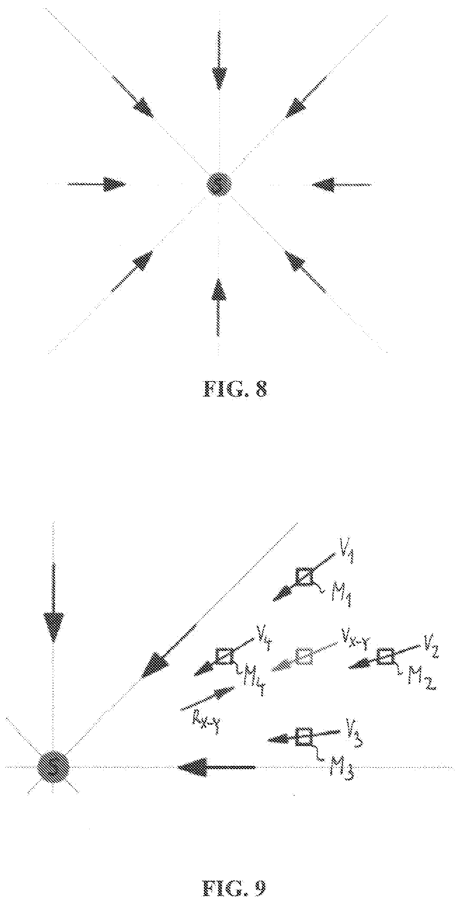

Figure 8 shows the magnetic field (top view on the south pole (S)) in case the magnet (2) is rotated 180. Figure 9 shows again the magnetic field (top view on the south pole (S)) with the four magnetometers (M1-M4) which are again above the magnet (2) in a plane perpendicular to the magnetic axis. The magnetic field strengths (V1-V4) measured by the magnetometers (M1-M4) are again vectorially added in the X-Y plane to a virtual vector (VX-Y). However, the (opposite) direction (RX-Y) does not indicate the direction in which the magnetometers (M1-M4) should be moved. The Z components of the measured magnetic field strengths (V1-V4) do not give a definite answer about the north-south position (NS) of the magnet (2) since the direction of a Z component depends on the distance between the magnetic axis and the relevant magnetometer, see figure 4.

If the north-south position (N-S) of the magnet (2) is not known, the correct direction of movement can still be derived based on the magnitudes of the measured magnetic field strengths (V1-V4). The highest magnetic field strengths are measured with the magnetometers closest to the magnetic axis. In the situation outlined in Figure 6, the magnetic field strengths (V1 and V2) measured by magnetometers M1 and M2 are smaller than the magnetic field strengths (V3 and V4) measured by magnetometers M3 and M4. In the situation outlined in figure 9, it is exactly the opposite. In this way the north-south position (N-S) of the magnet (2) can be determined, and the correct direction for moving can be indicated on the display (3) by means of the display elements (4).

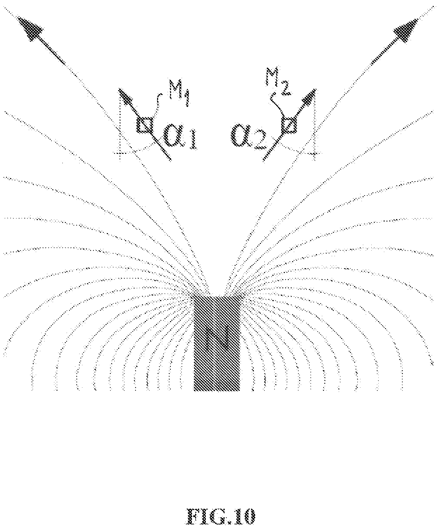

To more accurately determine the location of the magnet (2) in the X direction and Y direction, the neutral position is determined based on the mutual angles (α1-α4) of the measured magnetic field strengths (V1-V4) and the magnetic axis. If those angles (α1-α4) are equal, the neutral position is reached, as outlined in figure 10. This is shown on the display (3) by lighting up all eight display elements (4) simultaneously.

To also determine the location of the magnet (2) in the Z direction, the distance in the direction of the magnetic axis is determined on the basis of the magnitude of the mutual angles (α1-α4) the magnetic field strengths (V1-V4) measured in the neutral position and the magnetic axis. Using the known geometry of the magnetic field of the magnet (2), the location of the magnet (2) in the Z direction can be derived. That distance can then again be indicated on the display (3) by lighting up the display element (4) provided with the relevant number.

The three-dimensional location of the magnet (2) relative to the magnetometers (M1-M4) or the device (1) can thus be determined in a simple and quick manner and with great accuracy. In the context of the invention, terms such as "plane", "circular", "perpendicular", "parallel", "equal" and "zero" always mean "plane within applicable tolerances", "circular within applicable tolerances" and so on.

It will be clear that the invention is not limited to the exemplary embodiments given. The invention is defined by the appended claims.

## Claims

1. Method for determining the location of a bipolar magnet (2) located in a wall (13), the wall having a main plane, the magnet having a magnetic axis perpendicular to the main plane and a known geometry of its magnetic field, whereby the method comprises:
- measuring magnetic field strengths (V1-V4) at several measuring locations in the vicinity of the magnet by means of a device (1) comprising several spatially separated magnetometers (M1-M4) for this purpose and arranged in a plane;
- determining, by means of first means provided for that purpose, using an appropriate algorithm, a geometric quantity related to the location of the magnet on the basis of the magnetic field strengths measured by the magnetometers and on the basis of the geometry of the magnetic field of the magnet; and
- indicating a direction as a determined geometric quantity by means of second means (3,4) provided for this purpose, and
moving the device in the vicinity of the wall such that the magnetometers are in a plane perpendicular to the magnetic axis, and in the indicated direction to a neutral position in which the indicated direction in the plane perpendicular to the magnetic axis is zero,
whereby the neutral position is determined on the basis of the mutual angles (α1-α4) of the measured magnetic field strengths (V1-V4) and the magnetic axis, **characterized in that** the method further comprises:
indicating in the neutral position the distance of the magnet in the direction of the magnetic axis as a determined geometric quantity, whereby the distance is determined on the basis of the mutual angles (α1-α4) of the magnetic field strengths (V1-V4) measured in the neutral position and on the basis of the known geometry of the magnetic field of the magnet.

2. Method according to claim 1, whereby the magnetometers are arranged in a circular manner.

3. Method according to claim 1 or 2, whereby the second means comprise a display (3), and the determined direction (VX-Y) is indicated on the display by lighting up at least one of several display elements (4).

4. Method according to claim 3, whereby the display elements are arranged in a circular manner.

5. Method according to one of the preceding claims , whereby the second means comprise a display (3) and the determined distance is indicated on the display by lighting up at least one display element (4) provided with a number.

## Patentansprüche

1. Verfahren zum Bestimmen des Standorts eines bipolaren Magneten (2), der sich in einer Wand (13) befindet, wobei die Wand eine Hauptebene aufweist, wobei der Magnet eine magnetische Achse senkrecht zur Hauptebene und eine bekannte Geometrie seines Magnetfelds aufweist, wobei das Verfahren Folgendes umfasst:
- Messen von Magnetfeldstärken (V1-V4) an mehreren Messstandorten in der Nähe des Magneten mittels einer Vorrichtung (1), die zu diesem Zweck mehrere räumlich getrennte Magnetometer (M1-M4) umfasst und in einer Ebene angeordnet ist;
- Bestimmen, mittels erster Mittel, die zu diesem Zweck bereitgestellt sind, unter Verwendung eines geeigneten Algorithmus, einer geometrischen Größe in Bezug auf den Standort des Magneten basierend auf den von den Magnetometern gemessenen Magnetfeldstärken und basierend auf der Geometrie des Magnetfelds des Magneten; und
- Angeben einer Richtung als eine bestimmte geometrische Größe mittels zu diesem Zweck bereitgestellter zweiter Mittel (3,4) und
Bewegen der Vorrichtung in der Nähe der Wand, sodass sich die Magnetometer in einer Ebene senkrecht zur magnetischen Achse befinden, und in der angegebenen Richtung zu einer neutralen Position, in der die angegebene Richtung in der Ebene senkrecht zur magnetischen Achse Null ist, wobei die neutrale Position basierend auf den gegenseitigen Winkeln (α1-α4) der gemessenen Magnetfeldstärken (V1-V4) und der magnetischen Achse bestimmt wird, **dadurch gekennzeichnet, dass** das Verfahren ferner Folgendes umfasst:
Angeben, in der neutralen Position, des Abstands des Magneten in der Richtung der magnetischen Achse als eine bestimmte geometrische Größe, wobei der Abstand basierend auf den in der neutralen Position gemessenen gegenseitigen Winkeln (α1-α4) der Magnetfeldstärken (V1-V4) und basierend auf der bekannten Geometrie des Magnetfeldes des Magneten bestimmt wird.

2. Verfahren nach Anspruch 1, wobei die Magnetometer auf eine kreisförmige Weise angeordnet sind.

3. Verfahren nach Anspruch 1 oder 2, wobei die zweiten Mittel eine Anzeige (3) umfassen und die bestimmte Richtung (VX-Y) auf der Anzeige angegeben wird, indem mindestens eines von mehreren Anzeigeelementen (4) ausgeleuchtet wird.

4. Verfahren nach Anspruch 3, wobei die Anzeigeelemente auf eine kreisförmige Weise angeordnet sind.

5. Verfahren nach einem der vorhergehenden Ansprüche, wobei die zweiten Mittel eine Anzeige (3) umfassen und der bestimmte Abstand auf der Anzeige angegeben wird, indem mindestens ein mit einer Nummer bereitgestelltes Anzeigeelement (4) ausgeleuchtet wird.

## Revendications

1. Procédé permettant la détermination de l'emplacement d'un aimant bipolaire (2) situé dans une paroi (13), la paroi comportant un plan principal, l'aimant comportant un axe magnétique perpendiculaire au plan principal et une géométrie connue de son champ magnétique, moyennant quoi le procédé comprend :
- la mesure d'intensités de champ magnétique (V1 à V4) à plusieurs emplacements de mesure à proximité de l'aimant au moyen d'un dispositif (1) comprenant plusieurs magnétomètres spatialement séparés (M1 à M4) à cet effet et disposés dans un plan ;
- la détermination, au moyen de premiers moyens prévus à cet effet, en utilisant un algorithme approprié, d'une quantité géométrique relative à l'emplacement de l'aimant sur la base des intensités de champ magnétique mesurées par les magnétomètres et sur la base de la géométrie du champ magnétique de l'aimant ; et
- l'indication d'une direction en tant que quantité géométrique déterminée au moyen de seconds moyens (3, 4) prévus à cet effet, et
le déplacement du dispositif à proximité de la paroi de sorte que les magnétomètres soient dans un plan perpendiculaire à l'axe magnétique, et dans la direction indiquée vers une position neutre dans laquelle la direction indiquée dans le plan perpendiculaire à l'axe magnétique est nulle, moyennant quoi la position neutre est déterminée sur la base des angles mutuels (α1 à α4) des intensités de champ magnétique mesurées (V1 à V4) et de l'axe magnétique, **caractérisé en ce que** le procédé comprend en outre :
l'indication dans la position neutre de la distance de l'aimant dans la direction de l'axe magnétique en tant que quantité géométrique déterminée, moyennant quoi la distance est déterminée sur la base des angles mutuels (α1 à α4) des intensités de champ magnétique (V1 à V4) mesurées dans la position neutre et sur la base de la géométrie connue du champ magnétique de l'aimant.

2. Procédé selon la revendication 1, moyennant quoi les magnétomètres sont agencés de manière circulaire.

3. Procédé selon la revendication 1 ou 2, moyennant quoi les seconds moyens comprennent un affichage (3), et la direction déterminée (VX-Y) est indiquée sur l'affichage par éclairage d'au moins un parmi plusieurs éléments d'affichage (4).

4. Procédé selon la revendication 3, moyennant quoi les éléments d'affichage sont agencés de manière circulaire.

5. Procédé selon l'une des revendications précédentes, moyennant quoi les seconds moyens comprennent un affichage (3) et la distance déterminée est indiquée sur l'affichage par éclairage d'au moins un élément d'affichage (4) doté d'un numéro.
